Europäisches Patentamt

European Patent Office

Office européen des brevets

(11) Publication number: **0 050 475**
**B1**

(12) **EUROPEAN PATENT SPECIFICATION**

(45) Date of publication of patent specification: **15.05.85**

(21) Application number: **81304798.2**

(22) Date of filing: **14.10.81**

(51) Int. Cl.⁴: **G 01 R 31/26**

(54) **Scanning-image forming apparatus using photo electric signal.**

(30) Priority: **15.10.80 JP 145746/80 u**

(43) Date of publication of application:
**28.04.82 Bulletin 82/17**

(45) Publication of the grant of the patent:
**15.05.85 Bulletin 85/20**

(84) Designated Contracting States:
**DE FR GB NL**

(56) References cited:

SOLID STATE TECHNOLOGY, volume 20, no. 9,
September 1977 H.F. MATARE "Photoelectric
scanning of wafer inhomogenetics" pages 56 to
60
JAPANESE JOURNAL OF APPLIED PHYSICS,
volume 20, no. 2, February 1981 TOKYO (JP) C.
MUNAKATA et al. "Non-destructive method of
observing inhomogenetics in p-n junction,
with a chopped photon beam", pages L137-
L140

(73) Proprietor: **Hitachi, Ltd.**
**5-1, Marunouchi 1-chome**
**Chiyoda-ku Tokyo 100 (JP)**

(72) Inventor: **Munakata, Chusuke**
**2196-91, Hirai Hinodemachi**
**Nishitama-gun Toyko (JP)**
Inventor: **Kohno, Hideki**
**4-10-23-305, Takaido-higashi**
**Suginamai-ku Tokyo (JP)**

(74) Representative: **Paget, Hugh Charles Edward**
**et al**
**MEWBURN ELLIS & CO. 2/3 Cursitor Street**
**London EC4A 1BQ (GB)**

Courier Press, Leamington Spa, England.

# Description

This invention relates to an image forming apparatus which displays at a high resolving power a photo-electric signal such as photo-electric voltage generated by scanning the surface of a semiconductor specimen with a photon beam.

In one known form of apparatus for interpreting information recorded on an appropriate medium by the use of a particle beam, or an apparatus for characterising semi-conductors by the use of a particle beam, improving the resolving power is an important feature when a flying-spot scanning image is formed. The fundamental idea that a specimen is irradiated with the primary beam in the shape of a spot and that a signal generated from the specimen is used for obtaining the scanning image, has previously been achieved in a scanning electron microscope (hereinbelow, abbreviated to "SEM") by utilizing an electron beam as the primary beam and secondary electrons emitted from the specimen as the signal source. As is well known, in the SEM, the resolving power is determined by the diameter of the primary electron beam, and hence the diameter of the primary electron beam usually several tens of nanometers (several hundred Å) is reduced down to several tenths of a nanometer by employing several stages of electron lenses. Accordingly, unless the specimen is an electrical insulator, the resolving power will not be restricted by the properties of the specimen.

In contrast, in the system in which the scanning image is obtained by utilizing a photo-electric voltage as the signal source, unless the diameter of the primary photon beam is extremely large, the resolving power will be determined by the diffusion length of minority carriers in a semiconductor which contributes to the generation of the photo-electric voltage, rather than by the diameter of the photon beam. By way of example, even when the diameter of the photon beam is made infinitesimal, the resolving power does not increase, since the resolving power is determined by the extent to which the minority carriers excited by the photon beam spread. If it is assumed that the minority carriers are holes, the diffusion length of which is denoted by $L_p$, then the formation of the scanning image is, in effect, equivalent to measuring the specimen with a probe which has a diameter of $2 L_p$. Letting $r$ denote the radius of the photon beam, the diameter thereof is $2 r$, and $2 r \ll 2 L_p$ holds in many cases. With regard to the resolving power, the diameter of the photon beam is not a very important factor. In this respect, the concept of the scanning image is basically different from that of the scanning image of the SEM.

The fact that the scanning image which utilizes the photo-electric signal such as photo-electric voltage, depends upon the diffusion length $L_p$, gives rise to a phenomenon which is substantially different from that of the SEM referred to above.

Where the diffusion length $L_p$ varies depending upon semiconductor specimens, or where the diffusion length $L_p$ varies depending on its position within a given semiconductor specimen, not only does the resolving power change, but also the absolute values or amplitudes of the signals become substantially different. On the other hand, in the SEM, the mean value of the signal (the secondary electrons) will not considerably change unless the current of the primary electron beam fluctuates. It is accordingly natural that, in obtaining the scanning image, the gain of the signal amplifier need not be substantially changed.

This is based on the fact that the variation of the signal in the case of utilizing the photo-electric signal such as photo-electric voltage depends upon the diffusion length $L_p$. It is well known that, when the intensity of light is constant, the density $\Delta P$ of minority carriers to be generated is dependent upon the lifetime $\tau_p$ of the minority carriers. The minority carrier density is given by the following equation:

$$\Delta P = K_1 \tau_p \qquad (1)$$

In the above equation $K_1$ denotes a proportionality factor. When the photo-electric voltage is indicated by $\Delta V_o$, it is given by the following equation where B denotes another proportionality factor:

$$\Delta V_o = B \Delta P \qquad (2)$$

$$= B \cdot K_1 \cdot \tau_p \qquad (2')$$

On the other hand, the diffusion length $L_p$ is given by the following equation where $D_p$ denotes a diffusion constant:

$$L_p = \sqrt{D_p \tau_p} \qquad (3)$$

From equations (2') and (3), it will be appreciated that the equation

$$\Delta V_o = B \cdot K_1 \frac{L_p^2}{D_p} \qquad (4)$$

hold, and it is understood that the photo-electric voltage $\Delta V_o$ is proportional to the square of the diffusion length $L_p$. The proportionality of the photo-electric voltage $\Delta V_o$ to the square of the diffusion length $L_p$ is a phenomenon which is very effective for finding the variation of the diffusion length $L_p$ (namely, the variation of the lifetime $\tau_p$) within a given semiconductor specimen.

In particle beam recording, however, when the diffusion length $L_p$ varies depending on position within the semiconductor wafer, the brilliance of the background (a part where characters etc. are not recorded) of a recorded image or information varies depending on position. In an extreme case, the brilliance increases on part of a cathode-ray tube for obtaining the recorded image, with the result that halation arises on the picture. Simultaneously, the resolving power is conspicuously low in that part of the cathode ray tube. Eventually, the interpretation of the recording in the part where the diffusion length $L_p$ is great becomes impossible for the above two reasons. When the gain of the signal amplifier is reduced in order to prevent the halation, the brilliance of the other part of the cathode ray tube becomes insufficient, and the formation of the recorded image becomes impossible.

As a countermeasure against the occurrence of such partial extreme deviation in the signal intensity, it has been proposed to prevent the halation by the use of the so-called logarithmic amplifier having a logarithmic gain. However, it will be apparent, that this measure does not afford an adequate solution. The reason is that, whereas it is required on one hand to form a recorded image of high contrast on the basis of a minute signal difference, the use of the logarithmic amplifier renders it impossible to uniformly magnify the minute difference of the signals.

In this respect, in the SEM referred to above, the magnitude of the signal is determined by the intensity of the electron beam. Therefore, unless the electron beam intensity fluctuates, the brilliance of the background will not greatly change with position.

We will now consider the case of sensing uniformity in the p-n junction of a semiconductor (the state in which junction characteristics deteriorate partly). In this case, one wishes to sense whether the proportionality factor B in equation (4) varies depending on position. However, when the diffusion length $L_p$ varies greatly with position, the change of the background is too great to extract only the variation of the proportionality factor B.

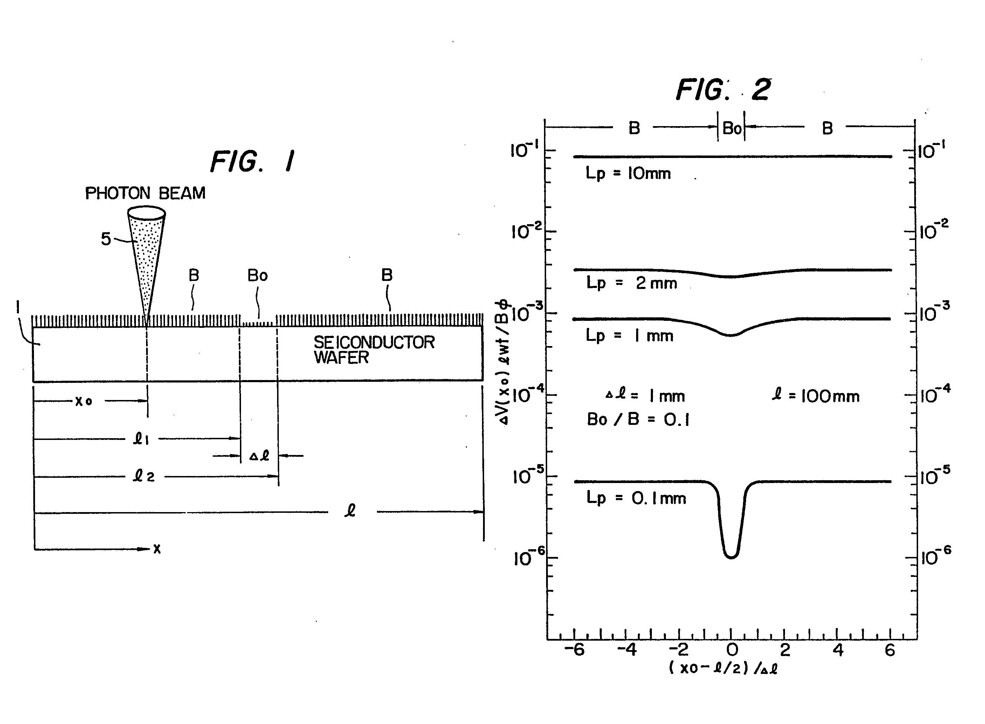

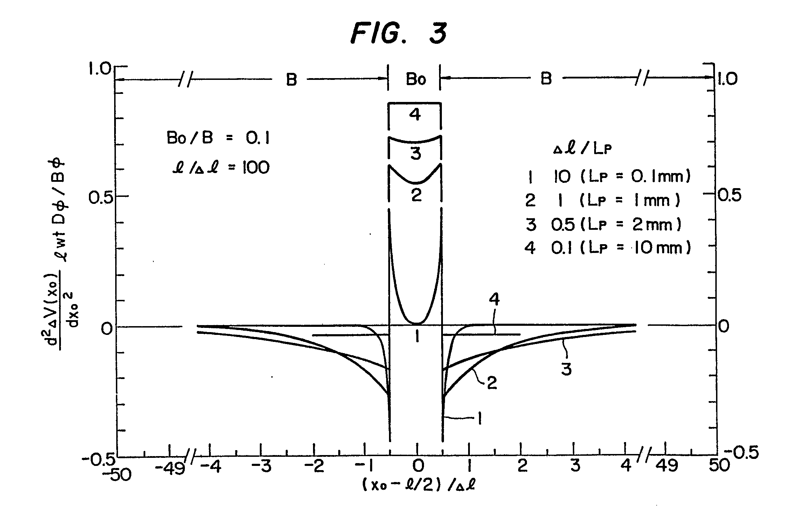

As to the case of sensing the variation of the proportionality factor B, the results of experimental study will now be described with reference to Figure 1 of the accompanying drawings, which illustrates a case where, in a specimen (semiconductor wafer) 1 having a length l, a width $w$ and a thickness $t$, a region having a proportionality factor $B_o$ exists over a range of a minute length $\Delta l$ in the central part of the specimen in the lengthwise direction thereof. Whether or not the state of $B_o = 0.1 \times B$ can be accurately sensed under the conditions of l=100 mm and $\Delta l$=1 mm, is illustrated as a function of the position $X_o$ of a photon beam 5 as shown in Figure 2 of the accompanying drawings. In Figure 2, the ordinate axis represents the signal voltage, which is normalized by the size $l \cdot w \cdot t$ of the semiconductor specimen l, the photon flux $\phi$ and the proportionality factor B.

It will be observed from Figure 2 that the increase of the diffusion length $L_p$ results in an increase in the signal voltage. Simultaneously, the situation is clearly illustrated in which the resolving power falls to render the part of the

proportionality factor $B_o$ indistinguishable. In case of $L_p$=0.1 mm, it is clearly shown that the proportionality factor $B_o$ is smaller than the proportionality factor B. In contrast, at $L_p$=10 mm, it is shown that discrimination of the proportionality factor $B_o$ is impossible. Moreover, the signal intensity increases to approximately $10^4$ times, and it is a fluctuation which cannot be handled with conventional image forming systems. Accordingly, a countermeasure is necessary.

Finally, it is known to scan wafer inhomogeneities in semiconductor devices by photo-electric methods, as disclosed in an article in "Solid State Technology" September 1977 (Vol. 20 No. 9) by H. F. Mataré. This article reviews the methods of testing wafer homogeneity and discloses wafer test equipment. The method disclosed is based on photo-electrically producing a replica of a wafer subject to a multitude of Schottky barriers. The wafer to be tested is fitted into a holder where pressure contact between the wafer, a back plate and a wire mesh is made. Light from a flying spot scanner is injected through a front glass plate and the mesh onto the wafer surface. The injection causes local depressions in the Schottky barrier heights and corresponding voltage variations across the wafer package, which are amplified. As the heights of the local Schottky barriers are dependent on the local wafer resistivity and conductivity type, the scanning in the X- and Y-directions produces a voltage replica of the resistivity variations in the wafer under test.

It is an object of the present invention to overcome the above two disadvantages and thus firstly prevent a fall in the resolving power due to an increase in the diffusion length $L_p$, and secondly suppress the increase of the background signal due to the increase of the diffusion length $L_p$.

According to the present invention, there is provided a scanning image-forming apparatus for scanning a semiconductor specimen with a beam of photons to develop a photo-electric signal in said specimen and using said signal to provide an image of said specimen, comprising photon beam generation means for generating said photon beam, photon beam scanning means for scanning a surface of said semiconductor specimen with said photon beam, detection means for detecting said photo-electric signal generated in said semiconductor specimen as a result of scanning with said photon beam, and display means, characterised by differentiating circuit means for providing a signal representing the second order differential of the amplified photo-electric signal, the display means being arranged to display an image by employing said second order differential signal for modulating the brightness of the display.

The present invention will now be described in greater detail by way of example with reference to the remaining figures of the accompanying drawings, wherein:—

Figure 3 is a diagram of the relationships between the irradiation point of a photon beam and the photo-electric voltage as depicted in order to explain the basic principle underlying this invention;

Figure 4 is a diagram of the fundamental arrangement of a scanning-image forming apparatus using a photo-electric signal embodying this invention; and

Figure 5 is a detailed block diagram of the derivative circuit shown in Figure 4.

The basic principle underlying the present invention will now be described. As already described, the image forming system which utilises a photo-electric signal such as photo-electric voltage generated in a semiconductor specimen by irradiating it with a photon beam has the special feature of an increase in the background signal attendant upon the lowering of the resolving power. We have found that, in an image forming system which utilizes a photo-electric signal such as a photo-electric voltage, this disadvantage can be substantially eliminated by the use of second order differentiation.

Figure 3 illustrates results obtained by subjecting the signals indicated in Figure 2 to a second order differentiation (both the abscissa and the ordinates axes in Figure 3 are the same as those in Figure 2). In the case of $L_p=10$ mm, the detection of the part having the proportionality factor $B_o$ is impossible in Figure 2, whereas the part having the proportionality factor $B_o$ is clearly indicated in Figure 3. Moreover, the magnitudes of the signals in Figure 3 are within 2 times in the range of $L_p=10mm-0.1$ mm as long as the contour parts are concerned. It can therefore be said that the variation of $10^4$ times shown in Figure 2 has been removed substantially perfectly. In the image formation, a positive signal is usually used for enhancing the brightness. According to the results of Figure 3, therefore, when the diffusion length $L_p$ is small, there is the tendency that the signal falls in the central part, so the recorded image becomes darker.

As thus far described, in image formation utilising a photo-electric voltage, the operation of second order differentiation is greatly effective in enhancing the image quality. The effect is based on a special feature in the photovoltaic effect, which we have discovered.

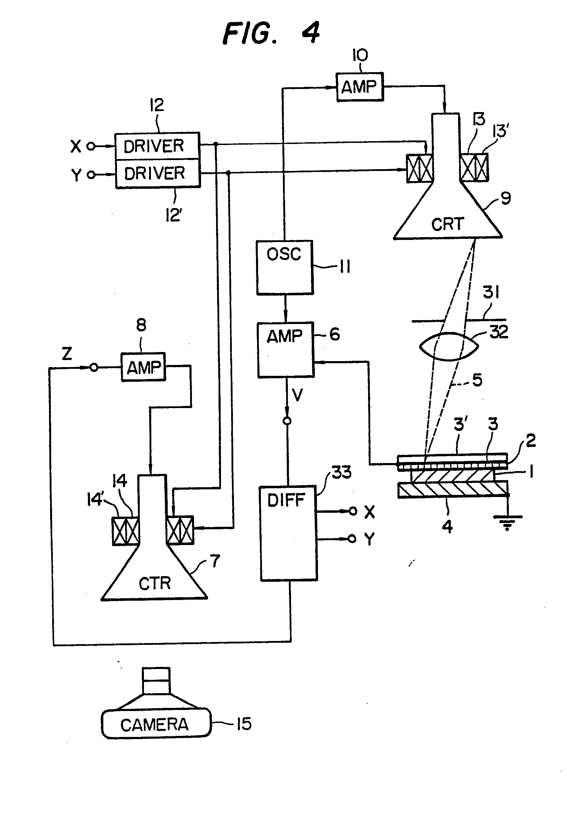

Figure 4 shows the fundamental arrangement of a scanning-image forming apparatus using a photo-electric signal.

Referring to Figure 4, a semiconductor specimen 1 to be observed is sandwiched in between a transparent electrode 3 located on a glass substrate 3' and a metal electrode 4, with an intermediate transparent spacer 2. When a photon beam 5 is projected through the transparent electrode 3, a photo-electric voltage is developed across the front and rear surfaces of the semiconductor specimen 1. When the photon beam 5 is pulsed or chopped, the photo-electric voltage also pulses. Therefore, even though the electrode is not formed directly on the front surface of the semi-conductor specimen 1, the photo-electric voltage can be sensed by the transparent electrode 3 through the electrical capacitance which is formed by the spacer 2.

Since the sensed photo-electric voltage is alternating, it should desirably be demodulated. The sensed voltage is introduced into a demodulating amplifier 6, in which it is demodulated into a D.C. signal. The D.C. signal is supplied to a cathode-ray tube (abbreviated to "CRT") 7 for forming a recorded image. Usually, the output of the demodulating amplifier 6 is introduced directly into a brightness modulation amplifier 8. However, in carrying out the present invention, the so-called video signal V being the output of the demodulating amplifier 6 is subjected to second order differentiation by a second derivative circuit 33 to be described later, and the second derivative signal is supplied to the CRT 7 via a brightness modulation amplifier 8 as a brightness modulation signal Z.

The demodulating amplifier 6 is conventionally a phase sensitive amplifier for the purposes of enhancing the S/N (signal-to-noise) ratio of the signal and utilizing the phase information of the photo-electric voltage as the signal. The phase sensitive amplifier demodulates and amplifies the signal in synchronism with the pulse frequency of the photon beam 5, and a lock-in amplifier is mentioned as the amplifier of this type.

On the other hand, the photon beam 5 may of course be a laser beam, but the case of employing a CRT 9 as a light source is illustrated here. Light from the bright spot of the CRT 9 forms the photon beam 5 through an aperture 31 as well as a condenser lens 32. The reason why the CRT 9 is used as the light source is that the pulsing of and the scanning with the photon beam 5 are facilitated. More specifically, the photon beam 5 can be readily pulsed by supplying a signal at an appropriate frequency from an oscillator 11 to a brightness modulation amplifier 10 of the CRT 9. Accordingly, when the signal from the oscillator 11 is supplied to the demodulating amplifier 6, eventually the photo-electric signal can be demodulated in synchronism with the frequency of the photon beam 5.

In order to deflect and scan the electron beams of the CRT 9 and CRT 7, appropriate deflection signals are supplied from deflection signal amplifiers 12 and 12' to deflection coils 13 and 13', and 14 and 14' of the respective CRTs 7 and 9. Thus, a bright spot which moves in synchronism with the photon beam 5 can be formed on the screen of the CRT 7, and a scanning image based on the photo-electric voltage can be formed on the screen of the CRT 7 with high resolving power by the photo-electric signal which has already been supplied. The image is recorded by a camera 15. The inputs X and Y to the deflection signal amplifiers 12 and 12' indicate the deflection signals in the X- and Y-directions respectively as will be described later.

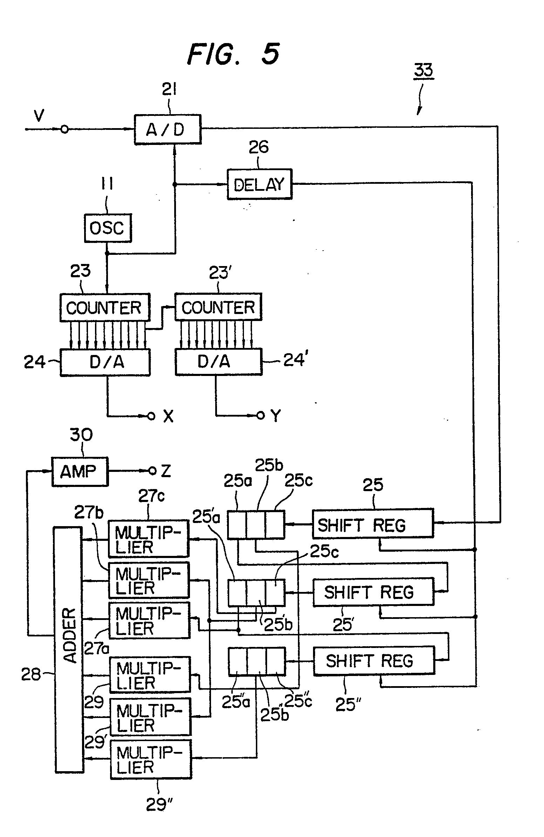

Figure 5 shows a detailed circuit diagram of the derivative circuit 33 for obtaining the second order differential signal referred to above. In order to digitize the signal, the analog video signal V is converted into digital values by the use of an A/D (analog-to-digital) converter 21. In the digitization, addressing is made time-sequentially, and hence, the A/D converter 21 is driven with the signal from the oscillator 11 producing the deflection signal of the photon beam 5. The deflection signal is generated in the form of integrating the number of pulses of a clock signal from the oscillator 11. For this purpose, a 10-bit binary counter 23 is used. The signal of the counter 23 is converted by a D/A (digital-to-analog) converter 24 into an analog value, which is used as the X-directional deflection signal X. When the 10-bit binary counter 23 has counter 515 pulses, it is reset to zero and begins to count again. Therefore, the X-directional deflection signal X is a saw-tooth wave. On the other hand, the Y-direction is scanned stepwise every 515th pulse (corresponding to one scanning in the X-direction). Therefore, a 10-bit binary counter 23' is driven by receiving a signal from the final stage of the counter 23 for the X-deflection. Then, when the X-directional deflection signal X is formed, the Y-directional deflection signal Y is similarly formed by a D/A converter 24'. Both the signals X and Y are supplied to the CRT driving circuits 12 and 12' in Figure 4, respectively.

The video signal converted into the digital value by the A/D converter 21 synchronous with the deflection signal is supplied to serially-connected shift registers 25, 25' and 25'' in succession at the clock pulse rate of the deflection signal. The shift registers have 515 bits in correspondence with the 515 digitized points (resolving points) of the deflection signal. It is to be understood however, that the capacity of the shift registers may be changed in correspondence with the number of digitized points of the deflection signal. The so-called depths of the respective bits of the shift registers 25, 25' and 25'' need to be varied in accordance with the gray scale of the video signal. In this example, there are 9 bits (division by 512) for the purpose of conforming with a signal variation of 100 times. Among the 515 time-sequential signals per scanning, three points are especially extracted. The bits of these points are indicated by 25a, 25b and 25c; 25'a, 25'b and 25'c; and 25''a, 25''b and 25''c. The digitized video signal from the A/D converter 21 are stored in the shift registers 25, 25' and 25'' with circuit delays. In order to precisely execute the addressing within the shift registers 25, 25' and 25'', these shift registers are controlled from the clock pulse signal from the oscillator 11 which is passed through a delay circuit 26.

At the point of time when the first scanning in the X-direction has ended, the first signal lies in the bit 25a and the subsequent signals lie in the bits 25b, 25c . . ., and the signals are stored in all the bits of the shift register 25. Next, when the second scanning starts, the signals shift from the bit 25a to the shift register 25'. At the point of time when the second scanning has ended, the first signal of the first scanning lies in the bit 25'a. In this manner, at the point of time when the third scanning has ended, the first signal of the first scanning lies in the bit 25''a, the first signal of the second scanning in the bit 25'a and the first signal of the third scanning in the bit 25a.

From a different viewpoint, under this state, the signals of three points in the X-direction and three points in the Y-direction are arrayed so as to surround the bit 25'b.

As is well known in the art of image processing, the second differential of a signal is attained by multiplying the signal of a noted point and signals on the left and right thereof by predetermined weighting coefficients and then combining the resultant signals. More specifically, in the X-direction, the signal of the bit 25'b and the signals of the bits 25'a and 25'c on the left and right thereof are multiplied by predetermined coefficients with multipliers 27b, 27a and 27c respectively, and the resultant signals are summed up by means of an adder 28. Since the second differential is similarly required in the Y-direction, the signals of the bit 25'b and of the bits 25b and 25''b over and under the bit 25'b are multiplied by weighting coefficients in multipliers 29', 29 and 29'' respectively, and the resultant signals are summed up by means of the adder 28.

Thus, the second differential is completed as to the second point of the second scanning. An output from the adder 28 may be subjected to an impedance change by an amplifier 30 whose output is transmitted to the brightness modulation circuit 8 of the image forming CRT 7 as a brightness modulation signal Z.

Upon initiation of the fourth scanning, the differential operation shifts to the third point of the second scanning. Thus, second differential signals are consecutively formed in succession.

In this case, obviously the first scanning signal and the last 515th scanning signal cannot be differentiated. Likewise, the initial point and the terminal point cannot be differentiated in each scanning. However, both are 2/515 of the total, and there is no significant disadvantage even when this extent of information is lost from the recorded image.

As described above in detail, a scanning image can be formed at a high resolving power which could not have previously been obtained, and this is greatly effective in practical use. Although, in the above described embodiment, a signal generated by a photo-electric voltage has been described by way of example, it will be understood that the invention is not restricted thereto but is also applicable to other photo-electric signals generated from a semiconductor specimen by the irradiation with light, such as photo-electric currents, or a photo-conductive effect.

**Claims**

1. A scanning image-forming apparatus for scanning a semiconductor specimen (1) with a beam (5) of photons to develop a photo-electric signal in said specimen and using said signal to provide an image of said specimen, comprising photon beam generation means (9) for generating said photon beam (5), photon beam scanning means (12, 12') for scanning a surface of said semiconductor specimen (1) with said photon beam, detection means (3, 4) for detecting said photo-electric signal generated in said semiconductor specimen as a result of scanning with said photon beam, and display means (7), characterised by differentiating circuit means (33) for providing a signal representing the second order differential of the amplified photo-electric signal, the display means being arranged to display an image by employing said second order differential signal for modulating the brightness of the display.

2. A scanning image-forming apparatus as defined in claim 1, wherein said photon beam (5) is a photon beam which is pulsed at a predetermined frequency.

3. A scanning image-forming apparatus as defined in claim 1 or claim 2, wherein said photo-electric signal is a photo-electric voltage signal which develops across front and rear surfaces of said semiconductor specimen (1).

4. A scanning image-forming apparatus as defined in any one of the preceding claims, wherein said photon beam generation means comprises a cathode-ray tube (9).

5. A scanning image-forming apparatus as defined in claim 2, wherein said photon beam generation means comprises a cathode-ray tube (9) whose brightness is modulated at said predetermined frequency.

6. A scanning image-forming apparatus as defined in any one of the preceding claims, wherein said photon beam scanning means comprises a cathode-ray tube (9) the beam deflection of which is controlled by deflection signals (X, Y).

7. A scanning image-forming apparatus as defined in any one of the preceding claims, wherein said detection means includes a transparent electrode (3) disposed on a front surface of said semiconductor specimen (1), and a metal electrode (4) disposed on a rear surface thereof.

8. A scanning image-forming apparatus as defined in claim 2, wherein amplification means (6) is provided to amplify the photo-electric signal from the detection means (3, 4), said amplification means being provided with a phase sensitive amplifier which uses said predetermined frequency as its reference signal.

9. A scanning image-forming apparatus as defined in any one of the preceding claims, wherein said display means comprises a cathode-ray tube (7).

10. A scanning image-forming apparatus according to any one of the preceding claims wherein the differential means (33) comprises means (25, 25', 25'') for storing values of the photo-response signal corresponding to successively scanned points on the surface of said specimen, and means (27, 29, 28) for combining the value for a given point with weighted values for surrounding points to obtain the second order differential signal (Z).

**Patentansprüche**

1. Abtastendes Bilderzeugungsgerät zur Abtastung eines Halbleitermusters (1) mit einem Photonenstrahl (5) zum Entwickeln eines fotoelektrischen Signals in dem Muster und zur Verwendung dieses Signals zum Erzeugen eines Bildes des Musters, umfassend eine Photonenstrahl-Erzeugungseinrichtung (9) zur Erzeugung des Photonenstrahls (5), eine Photonenstrahl-Abtasteinrichtung (12, 12') zur Abtastung einer Oberfläche des Halbleitermusters (1) mit dem Photonenstrahl, einer Erfassungseinrichtung (3, 4) zum Erfassen des aufgrund der Abtastung mit dem Photonenstrahl in dem Halbleitermuster erzeugten fotoelektrischen Signals, und eine Anzeigeeinrichtung (7), gekennzeichnet durch eine Differenzierschaltung (33) zur Erzeugung eines Signals, das das Differential zweiter Ordnung des verstärkten fotoelektrischen Signals darstellt, wobei die Anzeigeeinrichtung so angeordnet ist, daß sie ein Bild unter Verwendung des das Differential zweiter Ordnung darstellenden Signals zur Helligkeitsmodulation der Darstellung anzeigt.

2. Abtastendes Bilderzeugungsgerät nach Anspruch 1, wobei der Photonenstrahl (5) ein mit einer vorgegebenen Frequenz gepulster Photonenstrahl ist.

3. Abtastendes Bilderzeugungsgerät nach Anspruch 1 oder 2, wobei das fotoelektrische Signal ein fotoelektrisches Spannungssignal ist, das sich über die vordere und die hintere Oberfläche des Halbleitermusters (1) entwickelt.

4. Abtastendes Bilderzeugungsgerät nach einem der vorhergehenden Ansprüche, wobei die Photonenstrahl-Erzeugungseinrichtung eine Kathodenstrahlröhre (9) umfaßt.

5. Abtastendes Bilderzeugungsgerät nach Anspruch 2, wobei die Photonenstrahl-Erzeugungseinrichtung eine Kathodenstrahlröhre (9) umfaßt, deren Helligkeit mit der vorgegebenen Frequenz moduliert ist.

6. Abtastendes Bilderzeugungsgerät nach einem der vorhergehenden Ansprüche, wobei die Photonenstrahl-Abtasteinrichtung eine Kathodenstrahlröhre (9) umfaßt, deren Strahlablenkung durch Ablenksignale (X, Y) gesteuert ist.

7. Abtastendes Bilderzeugungsgerät nach einem der vorhergehenden Ansprüche, wobei die Erfassungseinrichtung eine an einer vorderen Oberfläche des Halbleitermusters (1) angeordnete transparente Elektrode (3) und eine an seiner hinteren Oberfläche angeordnete Metallelektrode (4) aufweist.

8. Abtastendes Bilderzeugungsgerät nach Anspruch 2, wobei zur Verstärkung des fotoelektrischen Signals aus der Erfassungseinrichtung (3, 4) eine Verstärkungseinrichtung (6) vorgesehen ist, die mit einem die vorgegebene Frequenz als sein Bezugssignal verwendenden phasenempfindlichen Verstärker versehen ist.

9. Abtastende Bilderzeugungseinrichtung nach einem der vorhergehenden Ansprüche, wobei die Anzeigeeinrichtung eine Kathodenstrahlröhre (7) umfaßt.

10. Abtastendes Bilderzeugungsgerät nach einem der vorhergehenden Ansprüche, wobei die Differenziereinrichtung (3) eine Einrichtung (25, 25', 25'') zur Speicherung von den nacheinander abgetasteten Punkten auf der Oberfläche des Musters entsprechenden Werten des Fotosignals une eine Einrichtung (27, 29, 28) zum Kombinieren des Wertes für einen gegebenen Punkt mit gewichteten Werten für Umgebungspunkte zur Erzielung des das Differential zweiter Ordnung darstellenden Signals (Z) umfaßt.

## Revendications

1. Appareil de formation d'images par balayage, servant à réaliser l'exploration par balayage d'un échantillon semiconducteur (1) à l'aide d'une faisceau (5) de photons de manière à produire un signal photoélectrique dans ledit échantillon et utiliser ledit signal de manière à produire une image dudit échantillon, incluant des moyens (9) servant à produire ledit faisceau de photons (5), des moyens (12, 12') d'exploration par balayage à l'aide du faisceau de photons, servant à explorer une surface dudit échantillon semiconducteur (1) par balayage à l'aide dudit faisceau de photons, des moyens de détection (3, 4) servant à détecter ledit signal photoélectrique produit dans ledit échantillon semiconducteur comme résultat de l'exploration par balayage dudit faisceau de photons, et des moyens d'affichage (7), caractérisé par un circuit différentiateur (33) servant à envoyer un signal représentant la différentielle du second ordre du signal photoélectrique amplifié, les moyens d'affichage étant agencés de manière à afficher une image moyennant l'utilisation dudit signal formé par la différentielle du second ordre de manière à moduler la luminosité dudit dispositif d'affichage.

2. Appareil de formation d'images par balayage selon la revendication 1, dans lequel ledit faisceau de photons (5) est un faisceau de photons qui est pulsé à une fréquence prédéterminée.

3. Appareil de formation d'images selon la revendication 1 ou 2, dans lequel ledit signal photoélectrique est un signal de tension photoélectrique qui se développe aux bornes des surfaces avant et arrière dudit échantillon semiconducteur (1).

4. Appareil de formation d'images par balayage selon l'une des revendications précédentes, dans lequel lesdits moyens de production du faisceau de photons comprennent un tube cathodique (9).

5. Appareil de formation d'images par balayage selon la revendication 2, dans lequel lesdits moyens de production du faisceau de photons comprennent un tube cathodique (9), dont la luminosité est modulée à ladite fréquence prédéterminée.

6. Appareil de formation d'images par balayage selon l'une quelconque des revendications précédentes, dans lequel lesdits moyens de production dudit faisceau de photons comprennent un tube cathodique (9), dont la déviation du faisceau est commandée par des signaux de déviation (X, Y).

7. Appareil de formation d'images selon l'une quelconque des revendications précédentes, dans lequel lesdits moyens de détection comprennent une électrode transparente (3) disposée sur une surface avant dudit échantillon semiconducteur (1), et une électrode métallique (4) disposée sur une surface arrière de cet échantillon.

8. Appareil de formation d'images par balayage selon la revendication 2, dans lequel lesdits moyens d'amplification (6) sont prévus de manière à amplifier le signal photoélectrique provenant des moyens de détection (3, 4), lesdits moyens d'amplification étant munis d'un amplificateur sensible à la phase et qui utilisent ladite fréquence prédéterminée en tant que signal de référence.

9. Appareil de formation d'images par balayage suivant l'une quelconque des revendications précédentes, dans lequel lesdites moyens d'affichage comprennent un tube cathodique (16).

10. Appareil de formation d'images par balayage suivant l'une quelconque des revendications précédentes, dans lequel les moyens différentiels comportent des moyens (25, 25', 25'') servant à mémoriser la valeur du signal photoélectrique correspondant à des points explorés successivement à la surface dudit échantillon, et des moyens (27, 29, 28) servant à combiner la valeur pour un point donné à des valeurs pondérées pour des points situés alentours de manière à obtenir le signal (Z) formé par la différentielle du second ordre.

FIG. 1

PHOTON BEAM

5

B    Bo         B

SEICONDUCTOR
WAFER

1

$x_o$

$\ell_1$

$\ell_2$

$\Delta\ell$

$\ell$

x

FIG. 2

B ⟶⟨Bo⟩⟵ B

$L_p = 10mm$

$L_p = 2 mm$

$L_p = 1 mm$

$\Delta\ell = 1 mm$          $\ell = 100mm$
$Bo / B = 0.1$

$L_p = 0.1 mm$

$\dfrac{\Delta V(x_o)\,\ell wt}{B\phi}$

$10^{-1}$  $10^{-2}$  $10^{-3}$  $10^{-4}$  $10^{-5}$  $10^{-6}$

-6  -4  -2  0  2  4  6

$(x_o - \ell/2)/\Delta\ell$

0 050 475

FIG. 3

# FIG. 4

# FIG. 5